# EUROPEAN PATENT APPLICATION

(11) **EP 4 675 888 A1**
(43) Date of publication of application: **07.01.2026**
(21) Application number: 24763596.4
(22) Date of filing: 13.02.2024
(51) Int. Cl.: H02J 13/00, B60L 3/00, B60L 50/60, B60L 53/14, B60L 53/62, B60L 58/16, G01R 31/371, G01R 31/3842, G01R 31/392, G16Y 10/40, G16Y 20/20, G16Y 20/30, G16Y 40/20, H01M 10/48, H02J 7/00

(54) **BATTERY ANALYSIS SYSTEM, BATTERY ANALYSIS METHOD, BATTERY ANALYSIS PROGRAM, AND STORAGE MEDIUM WITH BATTERY ANALYSIS PROGRAM RECORDED THEREIN**

(30) Priority: 28.02.2023 JP 2023029717
(71) Applicant: Panasonic Intellectual Property Management Co., Ltd., Kadoma-shi, Osaka 571-0057 (JP)
(72) Inventor: NAGASE, Ryosuke, Kadoma-shi, Osaka 571-0057 (JP)
(74) Representative: Novagraaf International SA
(86) International application number: PCT/JP2024/004842
(87) International publication number: WO 2024/181112

(57) **Abstract**

The balance between the accuracy of monitoring a battery pack and the amount of battery data stored is optimized. In a battery analysis system, a data receiving unit receives battery data of a battery pack installed in an apparatus via an apparatus (1) or a data relay system. A battery data retention unit stores the received battery data. A battery state analysis unit reads the stored battery data and analyzes the read battery data to estimate a battery state. In accordance with the state of the battery pack, a data acquisition control unit adaptively increases or decreases at least one of the acquisition frequency or a data acquisition item of the battery data received from the apparatus or the data relay system and stored in the battery data retention unit.

## Description

### TECHNICAL FIELD

The present disclosure relates to a battery analysis system, a battery analysis method, and a battery analysis program, each being configured to analyze the state of a battery.

### BACKGROUND ART

A battery analysis system configured to store battery data of a battery pack installed in an electric vehicle in a cloud database, read the stored battery data, and analyze the state of the battery pack installed in the electric vehicle has been put to practical use. With improvement in analysis function accuracy, the required amount of the data increases, which has caused a strain on the capacity of the cloud database. In addition, cloud server operation hours have increased.

Conventionally, battery data of a battery pack having no abnormalities, battery data of a battery pack suffering deterioration, and battery data of a battery pack having no abnormalities detected in an analysis result all have been commonly stored with the same sampling frequency.

Regarding the sampling frequency of battery data, Patent Literature 1 discloses a method for increasing data acquisition frequency when the deterioration state of a battery exceeds a certain level. Patent Literature 1 assumes only increasing the acquisition frequency of battery data, but does not assumes decreasing the acquisition frequency of battery data.

### Citation List

### Patent Literatures

Patent Literature 1: Japanese Unexamined Patent Application Publication No. 2021-86816

### SUMMARY OF THE INVENTION

By increasing the acquisition frequency of battery data with the above-mentioned method when battery deterioration proceeds, the monitoring of a battery pack can be enhanced, but the amount of data stored in a database increases. As described above, when the amount of battery data stored is smaller, the maintenance and operation cost of a server can be reduced.

The present disclosure has been made in view of these circumstances, and an object of the present disclosure is to provide a technology to optimize the balance between the accuracy of monitoring a battery pack and the amount of battery data stored.

To solve the above-mentioned object, a battery analysis system according to one aspect of the present disclosure includes: a data receiving unit configured to receive, via an apparatus or a data relay system, battery data of a battery pack installed in the apparatus in real time; a battery data retention unit configured to store the battery data received by the data receiving unit; a battery state analysis unit configured to read the battery data from the battery data retention unit, and analyze the battery data read to estimate a battery state of the battery pack; and a data acquisition control unit configured to, in accordance with the battery state analyzed by the battery state analysis unit, adaptively increase or decrease at least one of (i) an acquisition frequency of battery data that is received from the apparatus or the data relay system by the data receiving unit and stored in the battery data retention unit, or (ii) a data acquisition item of the battery data that is received from the apparatus or the data relay system by the data receiving unit and stored in the battery data retention unit.

Note that any combination of the above-mentioned constituents and what is obtained by converting between a device, a system, a method, a computer program, and a storage medium in the expression of the present disclosure are also effective as aspects of the present disclosure.

According to the present disclosure, the balance between the accuracy of monitoring a battery pack and the amount of battery data stored can be optimized.

### BRIEF DESCRIPTION OF THE DRAWINGS

Fig. 1 is a diagram to describe a battery analysis system according to an embodiment.
Fig. 2A is a diagram illustrating the configuration of a battery assembly system including a plurality of cells connected in series.
Fig. 2B is a diagram illustrating the configuration of a battery assembly system including a plurality of cell blocks connected in series.
Fig. 3 is a table illustrating some analysis functions of a battery pack to be provided to users by a battery analysis service provider.
Fig. 4 is a table illustrating determination criteria for determining the state of a battery pack and specific examples of processes executed based on the determination criteria.
Fig. 5A is a diagram illustrating Control Example 1 of controlling the acquisition frequency of battery data.
Fig. 5B is a diagram illustrating Control Example 2 of controlling the acquisition frequency of battery data.
Fig. 6 is a flowchart to describe Control Example 1 of controlling the amount of battery data by the battery analysis system according to the embodiment.
Fig. 7 is a flowchart to describe Control Example 2 of controlling the amount of battery data by the battery analysis system according to the embodiment.
Fig. 8 is a flowchart to describe Control Example 3 of controlling the amount of battery data by the battery analysis system according to the embodiment.
Fig. 9 is a flowchart to describe Control Example 4 of controlling the amount of battery data by the battery analysis system according to the embodiment.

### DETAILED DESCRIPTIONS

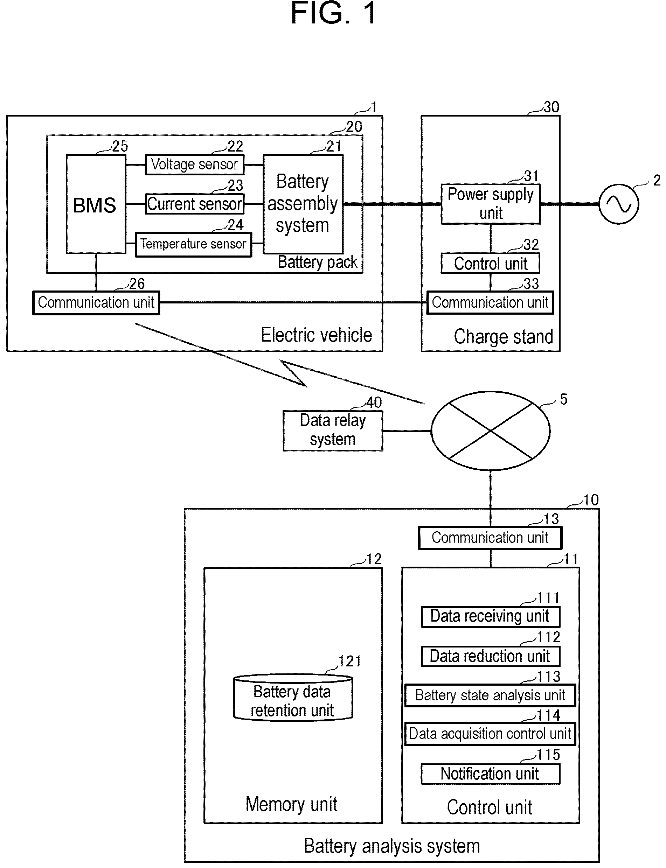

Fig. 1 is a diagram to describe battery analysis system 10 according to an embodiment. Battery analysis system 10 is a system to analyze the state of battery pack 20 installed in electric vehicle 1. In the present embodiment, battery analysis system 10 is built on a cloud server provided in a data center managed by a cloud service provider. A battery analysis service provider that provides an analysis service for battery pack 20 installed in electric vehicle 1 contracts with the cloud service provider to use a cloud server. Note that battery analysis system 10 may be built on a company's own server provided in a company's own facility of the battery analysis service provider or the data center.

Battery assembly system 21 included in battery pack 20 installed in electric vehicle 1 supplies electric power to a motor for driving (not illustrated). Battery assembly system 21 includes a plurality of cells or cell blocks connected in series. Note that, in the case of battery pack 20 including a large number of cells connected in series, battery assembly system 21 may be configured in such a manner that a plurality of battery modules each including a plurality of cells or cell blocks connected in series are connected in series.

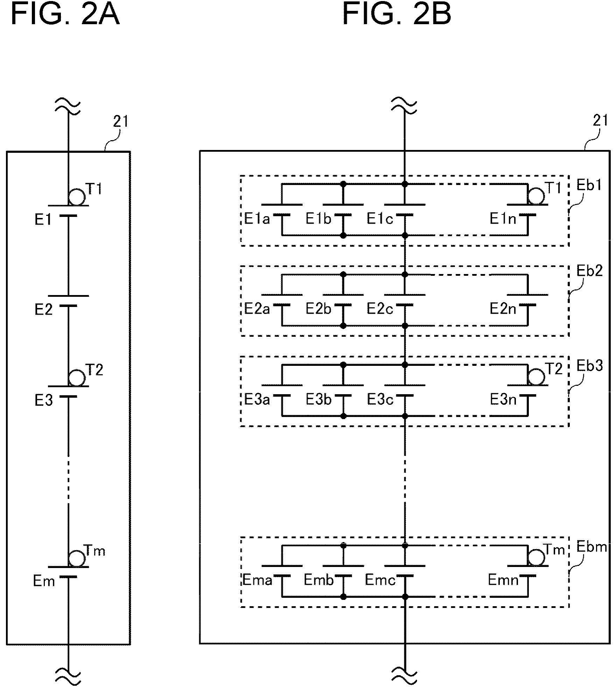

Fig. 2A is a diagram illustrating the configuration of battery assembly system 21 including a plurality of cells El-Em connected in series. Fig. 2B is a diagram illustrating the configuration of battery assembly system 21 including a plurality of cell blocks Ebl-Ebm connected in series. Each of cell blocks Ebl-Ebm includes a corresponding set of a plurality of cells Ela-Eln to Ema-Emn connected in parallel.

Lithium-ion battery cells, nickel hydride battery cells, lead battery cells, and other types of cells can be used as cells. Hereinafter, in the present specification, an example of using lithium-ion battery cells (nominal voltage: 3.6-3.7 V) is assumed. The number of cells or the cell blocks connected in series is determined in accordance with the voltage of a motor for driving. For example, when the number of the cells or the cell blocks connected in series is large, the system configuration illustrated in Fig. 2A or Fig. 2B is taken as one battery module unit, and battery assembly system 21 is configured with a plurality of battery modules connected in series.

Voltage sensor 22 is configured to measure voltages at both ends of cells El-Em or cell blocks Ebl-Ebm connected in series. A shunt resistance is connected in series to cells El-Em or cell blocks Ebl-Ebm connected in series. Current sensor 23 is configured to measure an electric current flowing through each of cells E1-Em or cell blocks Ebl-Ebm connected in series in accordance with voltages at both ends of the shunt resistance. Note that a Hall element may be used, instead of the shunt resistance. Temperature sensors 24 are provided at a plurality of observation points in battery pack 20 including battery assembly system 21. For example, thermistors T1-Tm are used as temperature sensors 24 and provided at a plurality of points in a surface of battery assembly system 21, as illustrated in Fig. 2A or Fig. 2B.

Battery management system (BMS) 25 is configured to manage the state of battery assembly system 21. As monitoring data items for battery pack 20, cell voltages of cells El-Em or cell blocks Ebl-Ebm measured by voltage sensor 22, a current flowing through battery pack 20 and measured by current sensor 23, and temperatures measured by temperature sensors 24 provided in battery pack 20 are monitored by BMS 25.

BMS 25 acquires the monitored cell voltages, current, and temperatures every predetermined sampling period (for example, 10 seconds, 30 seconds, or 1 minute) and stores the cell voltages, the current, and the temperatures in a non-volatile memory (not illustrated). To reduce the amount of data stored, BMS 25 may store only the maximum and minimum cell voltages out of the cell voltages. Furthermore, to reduce the amount of data stored, BMS 25 may store only the maximum and minimum temperatures out of the temperatures measured at the observation points.

BMS 25 estimates a state of charge (SOC) by using an open circuit voltage (OCV) method and a current integration method in combination. The OCV method is a method of estimating an SOC, based on the OCV of a cell to be measured and an SOC-OCV curve of the cell. The SOC-OCV curve of the cell is produced in advance, based on a characteristic test performed by a battery manufacturer, and registered in BMS 25 at the time of shipment.

The current integration method is a method of estimating an SOC, based on an OCV at the start of charge or discharge of a cell and an integrated value of measured currents. In the current integration method, as the charge-and-discharge time becomes longer, current measurement errors accumulate. Therefore, a weighted average of the SOC estimated by the current integration method and the SOC estimated by the OCV method is preferably used.

BMS 25 can convert the SOCs of cells El-Em or cell blocks Ebl-Ebm to their actual capacities, synthesize the actual capacities to calculate the actual capacity of battery pack 20, and estimate the SOC of battery pack 20, based on the actual capacity and the present full charge capacity of battery pack 20.

BMS 25 transmits battery data, including the cell voltages or the maximum and minimum cell voltages, the current, the temperatures or the maximum and minimum temperatures, and the SOC of battery pack 20, to an electronic control unit (ECU) (not illustrated) via an on-board network. Examples of the on-board network that can be used include a controller area network (CAN) and a local interconnect network (LIN).

Communication unit 26 has the function of executing communication signal processing to communicate with communication unit 33 of charge stand 30 and the function of executing radio signal processing for connection to network 5. For example, communication unit 26 can access network 5 by using a mobile phone network (a cellular network), wireless LAN, Vehicle to Infrastructure (V2I), Vehicle to Vehicle (V2V), an electronic toll collection system (ETC system), or dedicated short range communications (DSRC).

Network 5 is a generic term for communication channels, such as the Internet, a dedicated line, and a virtual private network (VPN), and any communication medium and any protocol can be applied thereto. Examples of the communication medium that can be used include a mobile phone network, wireless LAN, cable LAN, an optical fiber network, an ADSL network, and a CATV network. Examples of the communication protocol that can be used include Transmission Control Protocol (TCP)/Internet Protocol (IP), User Datagram Protocol (UDP)/IP, and Ethernet (registered trademark).

The ECU wirelessly connects to network 5 and transmits battery data received from BMS 25 directly to battery analysis system10 or to battery analysis system10 via data relay system40 in real time.

For example, in the case of using a delivery vehicle for business as electric vehicle 1, data relay system 40 includes: a server to be operated and managed by a delivery company that owns the delivery vehicle; and a terminal device (for example, PC). When battery data are transmitted to battery analysis system 10 via data relay system 40, the battery data of battery pack 20 installed in electric vehicle 1 managed by the delivery company can be stored also in the server operated and managed by the delivery company.

When charge stand 30 is connected to electric vehicle 1 by a charging cable, charge stand 30 can charge battery pack 20 of electric vehicle 1 with electric power supplied from commercial power system 2. In general, AC charging is applied for normal charging, meanwhile DC charging is applied for fast charging. When AC charging (for example, single-phase 100/200 V) is applied, a charge voltage or a charge current is controlled by a charger (not illustrated) in electric vehicle 1. When DC charging is applied, a charge voltage or a charge current is controlled by power supply unit 31 of charge stand 30. Power supply unit 31 includes a rectifier circuit, a filter, and a DC/DC converter. AC power supplied from commercial power system 2 is rectified by the rectifier circuit through full-wave rectification and smoothed with the filter to generate DC power. The DC/DC converter controls the voltage or current of the generated DC power.

As fast charging standards, for example, CHAdeMO (registered trademark), ChaoJi, GB/T, and a combined charging system (Combo) can be used. In CHAdeMO, ChaoJi, and GB/T, CAN is used as a communication protocol. In Combo, power line communication (PLC) is used as a communication protocol.

A charging cable for which the CAN protocol is used includes a communication line as well as a power line. When electric vehicle 1 and charge stand 30 are connected by the charging cable, the ECU of electric vehicle 1 establishes a communication channel with control unit 32 of charge stand 30. Note that, in a charging cable for which the PLC protocol is used, a communication signal is superimposed on a power line and transmitted.

Communication unit 33 of charge stand 30 has the function of executing communication signal processing to communicate with communication unit 26 of electric vehicle 1. Note that communication unit 33 may have the function of connecting to network 5.

Battery analysis system 10 includes control unit 11, memory unit 12, and communication unit 13. Communication unit 13 is a communication interface (for example, network interface card (NIC)) for connecting to network 5 by wired or wireless means.

Control unit 11 includes data receiving unit 111, data reduction unit 112, battery state analysis unit 113, data acquisition control unit 114, and notification unit 115. The function of control unit 11 can be realized by a combination of hardware and software resources or by a hardware resource alone. Examples of the hardware resource that can be used include CPU, ROM, RAM, a graphics processing unit (GPU), an application specific integrated circuit (ASIC), a field programmable gate array (FPGA), and other LSIs. Examples of the software resource that can be used include programs such as operating systems and applications. The above-mentioned programs may be recorded on a storage medium. By the use of the storage medium, the above-mentioned programs can be installed in the above-mentioned computers, for example. Here, the storage medium having the above-mentioned program recorded therein may be a non-transitory storage medium. The non-transitory storage medium is not limited to a particular one, but may be a storage medium such as CD-ROM.

Memory unit 12 includes a non-volatile storage medium such as HDD or SSD and stores various types of data. Memory unit 12 includes battery data retention unit 121. Data receiving unit 111 receives battery data of battery pack 20 installed in electric vehicle 1, directly from electric vehicle 1 or via data relay system 40. Data receiving unit 111 stores the received battery data in battery data retention unit 121.

Data receiving unit 111 receives specification information on at least one of battery pack 20 or electric vehicle 1 directly from electric vehicle 1 or via data relay system 40. Examples of the specification information on battery pack 20 include the type of battery pack 20, the model number of battery pack 20, and whether battery pack 20 is a new article or a secondhand article. Examples of the specification information on electric vehicle 1 include classification information, such as a vehicle model, a type, a fault history, and whether electric vehicle 1 is a commercial vehicle or a general-purpose passenger vehicle.

Data reduction unit 112 is capable of reducing the battery data received from electric vehicle 1 or via data relay system 40. A method for the data reduction will be described in detail later.

Battery state analysis unit 113 reads the battery data stored in battery data retention unit 121 with predetermined analysis timing and analyzes the read battery data to estimate a battery state. In the present embodiment, a battery analysis service provider provides a customer (hereinafter, referred to as a user) with various analysis functions for battery pack 20 (for example, state-of-health (SOH) analysis, cell balancing proposal, voltage abnormality determination, temperature abnormality determination, initial abnormality determination, internal short circuit detection, and sensor abnormality determination). The user selects a desired analysis item. Basically, when the number of analysis items selected is larger, a larger charge is incurred. Notification unit 115 notifies the user's terminal device of an analysis result via network 5. For example, when the user is the above-mentioned delivery company, notification unit 115 notifies an analysis result to a server of data relay system 40 or a terminal device.

In accordance with the state of battery pack 20, battery state analysis unit 113 adaptively increases or decreases at least one of the number of items of analysis using the battery data or the frequency of the analysis. Specific examples of the function will be described later.

In accordance with the state of battery pack 20, data acquisition control unit 114 adaptively increases or decreases at least one of the acquisition frequency or the data acquisition item of battery data received from electric vehicle 1 or data relay system 40 and stored in battery data retention unit 121. For example, data acquisition control unit 114 determines the transmission frequency of the battery data in accordance with the state of battery pack 20. Notification unit 115 notifies electric vehicle 1 or data relay system 40 of the transmission frequency of the battery data, the transmission frequency being determined by data acquisition control unit 114.

On receipt of the transmission frequency of the battery data from battery analysis system 10, the ECU of electric vehicle 1 transmits sampling frequency corresponding to the transmission frequency of the battery data to BMS 25. On receipt of the sampling frequency from the ECU, BMS 25 samples monitored cell voltages, a current, and temperatures of battery pack 20 with the received sampling frequency. Note that, without transmitting the sampling frequency to BMS 25, the ECU may transmit the battery data received from BMS 25 to battery analysis system 10 with the transmission frequency specified by battery analysis system 10.

On receipt of the transmission frequency of battery data from the battery analysis system 10, data relay system 40 transmits the battery data received from electric vehicle 1 to battery analysis system 10 with the transmission frequency specified by battery analysis system 10.

Data reduction unit 112 can reduce the battery data received from electric vehicle 1 or data relay system 40, at a reduction rate of the battery data (that corresponds to the transmission frequency of the battery data) determined by data acquisition control unit 114.

When changing the acquisition frequency of battery data to increase or decrease the amount of battery data stored in battery data retention unit 121, any one of the following processes is executed: (1) changing the sampling frequency of the battery data by BMS 25; (2) changing the transmission frequency of the battery data to be transmitted from the ECU to battery analysis system 10; (2)' changing the transmission frequency of the battery data to be transmitted from data relay system 40 to battery analysis system 10; and (3) changing whether or not to reduce the battery data by data reduction unit 112, and, if reducing, changing the reduction rate.

Data acquisition control unit 114, for example, determines a transmission data item of the battery data in accordance with the state of battery pack 20. In this case, data acquisition control unit 114 may determine a non-critical data item in accordance with selected analysis contents. For example, in battery temperature abnormality determination, a current, the maximum and minimum cell voltages, cell voltages, the maximum and minimum temperatures, and an SOC are used, meanwhile, in a first battery internal short circuit detection, the maximum and minimum temperatures and an SOC are not required.

For example, in the case where data acquisition control unit 114 determines to reduce the transmission data item of the battery data in accordance with the state of battery pack 20, when only the first battery internal short circuit detection is selected as an analysis item, the maximum and minimum temperatures and an SOC are specified as non-critical data items of the battery data. Notification unit 115 notifies electric vehicle 1 or data relay system 40 of the non-critical data items of the battery data having been determined as specified information on the transmission data item by data acquisition control unit 114.

On receipt of the non-critical data items of the battery data as specified information on the transmission data items from battery analysis system 10, the ECU of electric vehicle 1 transmits the received non-critical data items of the battery data to BMS 25. On receipt of the non-critical data items from the ECU, BMS 25 stops sampling the received non-critical data items or makes the sampling frequency of the received non-critical data items lower than the sampling frequency of other data items. Note that, without notifying BMS 25 of the non-critical data items, the ECU may stop the transmission of the non-critical data items of the battery data that are to be transmitted to battery analysis system 10 or make the transmission frequency of the non-critical data items lower than the transmission frequency of other data items. Even when an analysis item that requires data of the non-critical data items is selected at a later date, the sampling or transmission frequency of the non-critical data items are preferably changed to the minimum level of the sampling or transmission frequency with which the analysis of the item can be performed,

On receipt of the non-critical data items of the battery data as specified information on the transmission data items from battery analysis system 10, data relay system 40 stops transmitting the non-critical data items of the battery data to be transmitted to battery analysis system 10 or makes the transmission frequency of the non-critical data items lower than the transmission frequency of other data items.

When data acquisition control unit 114 determines to reduce the transmission data item of the battery data in accordance with the state of battery pack 20, data acquisition control unit 114 may change cell voltages to the maximum and minimum cell voltages and change temperatures at the observation points to the maximum and minimum temperatures, regardless of a selected analysis item. In contrast, when data acquisition control unit 114 determines to increase the transmission data item of the battery data in accordance with the state of battery pack 20, data acquisition control unit 114 may change the maximum and minimum cell voltages to cell voltages and change the maximum and minimum temperatures to temperatures at the observation points, regardless of a selected analysis item.

When battery pack 20 includes a large number of cells connected in series, the amount of data can be greatly reduced by changing the transmission data item from cell voltages to the maximum and minimum cell voltages. When the number of temperature sensors provided in battery pack 20 is large, the amount of data can be greatly reduced by changing the transmission data item from temperatures at the observation points to the maximum and minimum temperatures.

Notification unit 115 notifies electric vehicle 1 or data relay system 40 of the transmission data item of at least one of the voltage or temperature of the battery data determined by data acquisition control unit 114, as specified information on the transmission data item. Hereinafter, it is assumed that the transmission data items of both voltage and temperature of the battery data are changed.

On receipt of transmission item change information of voltage and temperature as specified information on the transmitted data items from battery analysis system 10, the ECU electric vehicle 1 transmits, to BMS 25, sampling item change information of voltage and temperature that corresponds to the received transmission item change information of voltage and temperature. On receipt of the sampling item change information of voltage and temperature from the ECU, BMS 25 changes voltage and temperature sampling items in accordance with the received sampling item change information of voltage and temperature. Note that, without notifying BMS 25 of the sampling item change information of voltage and temperature, the ECU may change the transmission data items of voltage and temperature of the battery data that are to be transmitted to battery analysis system 10

On receipt of the transmission item change information of voltage and temperature as the specified information on the transmission data items from battery analysis system 10, data relay system 40 changes the voltage and temperature transmission data items of the battery data that are to be transmitted to battery analysis system 10.

Data reduction unit 112 can delete or reduce data of the non-critical data items determined by data acquisition control unit 114, out of the battery data received from electric vehicle 1 or data relay system 40. In addition, data reduction unit 112 can change storage data items of voltage and temperature of the battery data that are received from electric vehicle 1 or data relay system 40 to the maximum and minimum cell voltages and the maximum and minimum temperatures. Changing the storage data items from cell voltages to the maximum and minimum cell voltages or changing the storage data items from temperatures at the observation points to the maximum and minimum temperatures is equivalent to data reduction.

When the amount of battery data stored in battery data retention unit 121 is increased or decreased by changing an acquisition data item of the battery data, any one of the following processes is executed: (1) changing whether or not to stop sampling the non-critical data item by BMS 25, changing the sampling frequency of the non-critical data item, or changing the sampling item of voltage and temperature; (2) changing whether or not to stop the transmission of the data of the non-critical data item from the ECU to battery analysis system 10, changing the transmission frequency of the non-critical data item, or changing the transmission item of voltage and temperature; (2)' changing whether or not to stop the transmission of the data of the non-critical data item from data relay system 40 to battery analysis system 10, changing the transmission frequency of the non-critical data item, or changing the transmission item of voltage and temperature; and (3) changing whether or not to delete the data of the non-critical data item by data reduction unit 112, changing whether or not to reduce the data of the non-critical data item, or changing whether or not to switch the storage data item of voltage and temperature to the maximum and minimum cell voltages and the maximum and minimum temperatures.

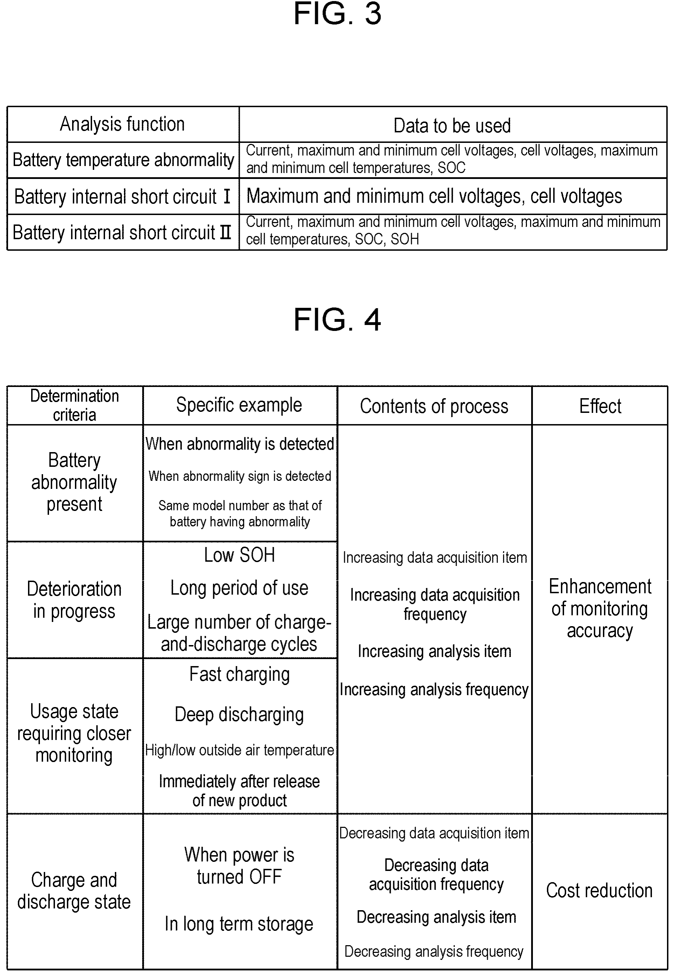

Fig. 3 is a table illustrating some analysis functions of battery pack 20 to be provided to users by a battery analysis service provider. Battery temperature abnormality is determined using a current, the maximum and minimum cell voltages, cell voltages, the maximum and minimum temperatures, and an SOC. As the maximum and minimum cell voltages, the maximum and minimum values of the cell voltages may be used, or both the cell voltages and the minimum cell voltages may be received from BMS 25. For example, battery temperature abnormality can be estimated as follows. During charging, battery states analysis unit 113 calculates a determination score to detect a sign of ignition, based on the current and temperatures of the cells or the cell blocks and elapsed time. The determination score is calculated, based on the theory of thermal energy.

Heating value of self-heating caused by a charging current is specified by Q (I, R, T).
Q: heating value [J], I: current [A], R: internal resistance [Ω], T: elapsed time [s]

The heating value Q of self-heating caused by a charging current increases as the current I is larger, the internal resistance R is higher, or the elapsed time T is longer.

Note that the internal resistance R of a battery depends on an SOC, a temperature, and an SOH. As the SOC is higher, the temperature is lower, or the SOH is lower, the internal resistance R is higher.

The heating value of a battery is specified by Q (m, c, ΔTp).
Q: heating value [J], m: mass of battery [g], c: specific heat of the entirety of battery [J/(g, K)], ΔTp: temperature rise in a period T [°C]
m and c can be collectively regarded as heat capacity C: [J/K].

As the heat capacity C is higher or the temperature rise ΔTp over the elapsed time T is larger, the heating value Q of the battery is larger.

When the heating value Q of self-heating caused by a charging current is not more than the heating value Q of the battery, thermal runaway caused by the self-heating can be prevented. However, the battery data basically do not include the material, mass, and internal resistance of each cell.

Battery state analysis unit 113 calculates a determination score indicating the relationship between the amount of current flowing in each single cell or cell block over a certain period and a temperature rise in each single cell or cell block over the certain period. In the present specific example, it is assumed that the maximum temperature is used as the temperature of each single cell or cell block. However, when temperatures at a plurality of observation points are received as the battery data, the temperature of an observation point closest to the single cell or cell block may be used as the temperature of the single cell or the cell block.

A determination score is calculated from the current I, the internal resistance R, the temperature rise Tp, and the elapsed time T, without using the heat capacity of each single cell or cell block. For example, the determination score may be specified by a ratio of a self-heating value to a temperature rise over a certain period. The internal resistance R of each single cell or cell block can be calculated by dividing a cell voltage by the current. Note that a battery temperature abnormality may be determined for all the cells or the cell blocks, or only for a single cell or a cell block having the maximum cell voltage. In this case, cell voltages can be removed from the data to be used.

The determination score can also be calculated from the current I, the temperature rise Tp, and the elapsed time T without using the internal resistance and the heat capacity of each single cell or cell block. For example, the determination score may be specified by a ratio of an integrated value of current to a temperature rise over a certain period. In this example, when the temperature rise is large relative to a charging current, the determination score is higher on the basis of the integrated value of current, meanwhile the determination score is lower on the basis of the temperature rise. In this case, the maximum and minimum cell voltages and cell voltages can be removed from the data to be used. Battery state analysis unit 113 compares the calculated determination score with a threshold determined based on data of an ignited battery and thereby estimates the occurrence of an abnormality in each single cell or cell block.

The maximum and minimum cell voltages and the cell voltages are used for a first battery internal short detection. In the first battery internal short circuit detection, an internal short circuit can be calculated, for example, as follows. Battery state analysis unit 113 generates smoothing voltages for cell voltages on a time-series basis. For example, battery state analysis unit 113 may use a primary low-pass filter to generate smoothing voltages for cell voltages or may calculate the moving average of cell voltages over a certain period to generate smoothing voltages for the cell voltages.

Battery state analysis unit 113 calculates a representative value of the smoothing voltages of a plurality of cells or cell blocks included in battery pack 20, excluding the smoothing voltage of a target single cell or cell block. For example, the median, the average, and the mode of the smoothing voltages of the cells or cell blocks excluding the target single cell or cell block are calculated as the representative value. Battery state analysis unit 113 calculates the difference between the smoothing voltage of the target single cell or cell block and the representative value of the smoothing voltages of the remaining cells or cell blocks. When the difference becomes equal to or larger than a set value during a predetermined period, battery state analysis unit 113 determines that the target single cell or cell block has developed an internal short circuit (more specifically, a micro short circuit). For example, when the difference increases by 5 mV or more in 12 hours, it is determined that an internal short circuit has occurred.

In a second battery internal short circuit detection, a current, the minimum and maximum cell voltages, cell voltages, an SOC, and an SOH. In the second battery internal short circuit detection, an internal short circuit can be calculated, for example, as follows. After the elapse of a predetermined determination period (for example, 10 minutes), battery state analysis unit 113 calculates the average of voltages of (m - 2) pieces out of m pieces of cells included in battery pack 20, excluding the maximum and minimum voltages. Battery state analysis unit 113 calculates the voltage difference between the calculated average voltage and the cell voltage of the target single cell or cell block.

Battery state analysis unit 113 calculates a voltage difference ΔV between the current voltage difference that is most recently calculated and the voltage difference calculated a time Δt earlier (for example, one hour earlier). Battery state analysis unit 113 compares the calculated voltage difference ΔV with a determination threshold. When the calculated voltage difference ΔV is larger than or equal to the determination threshold, battery state analysis unit 113 determines that an internal short circuit (more specifically, a micro short circuit) has occurred in the target single cell or cell block.

In the second battery internal short circuit detection, a linear function (a linear line) is introduced in which an SOC based on the initial capacity is used as an input variable, an OCV is used an output variable, and a positive slope is used. Battery state analysis unit 113 refers to the SOC-OCV curve in accordance with the SOH of each single cell or cell block and thereby estimates the SOC based on the initial capacity, the SOC corresponding to a measured voltage of the single cell or cell block. Note that, when battery pack 20 is under charging or discharging at the time of measuring the voltage of a single cell or a cell block, the measured voltage is not an OCV but a closed circuit voltage (CCV).

There is a simple method in which a CCV is passed through a noise reduction filter and the CCV obtained after the noise reduction is used as an OCV. There is a more precise method in which a CCV is corrected, based on a current and an internal resistance, to estimate an OCV. In this case, by correcting the internal resistance in accordance with a temperature, an SOC, and an SOH, accuracy can be enhanced. Battery state analysis unit 113 derives an alternative OCV by applying an SOC based on the initial capacity that corresponds to the measured voltage of each single cell or cell block to the above-mentioned linear function. Battery state analysis unit 113 calculates a voltage difference after normalization, based on the alternative OCV. In the second internal battery short circuit detection, a diagnosis can be performed more accurately than the first internal battery short circuit detection.

Fig. 4 is a table illustrating determination criteria for determining the state of battery pack 20 and specific examples of processes performed based on the determination criteria. Data acquisition control unit 114 can increase at least one of the acquisition frequency or the data acquisition item of the battery data when battery pack 20 has an abnormality or a sign of abnormality. Data acquisition control unit 114 can reduce at least one of the acquisition frequency or the data acquisition item of the battery data when an abnormality or a sign of abnormality in battery pack 20 is eliminated.

A specific example of determination criteria when battery pack 20 has an abnormality is that, as the result of an analysis performed by battery state analysis unit 113, an abnormality is detected in battery pack 20. Specific examples of the case in which an abnormality is detected in battery pack 20 include the above-described cases in which a battery temperature abnormality or a battery internal short circuit is detected and cases in which a battery voltage abnormality, a battery initial abnormality, or a temperature sensor abnormality is detected.

Other specific examples of the determination criteria when battery pack 20 has an abnormality are as follows: a temperature change per unit time exceeds a threshold; SOC data are discontinuous; and the difference between an SOC or SOH calculated by BMS 25 and an SOC or SOH calculated by battery state analysis unit 113 is larger than or equal to a predetermined value.

A specific example of determination criteria when battery pack 20 has a sign of abnormality is that, as the result of an analysis performed by battery state analysis unit 113, the above-mentioned determination score exceeds a threshold value. Another specific example of the determination criteria when battery pack 20 has a sign of abnormality is that battery data to be analyzed are battery data of battery pack 20 having the same model number as that of battery pack 20 in which an abnormality has actually occurred.

Data acquisition control unit 114 can increase at least one of the acquisition frequency or the data acquisition item of the battery data when battery pack 20 deteriorates beyond a reference level. Specific examples of determination criteria when the battery pack 20 deteriorates beyond the reference level are as follows: the SOH of battery pack 20 is lower than a reference level; a period of use having elapsed since the start of use of battery pack 20 exceeds a reference length; and the number of charge and discharge cycles of battery pack 20 exceeds a reference level.

Data acquisition control unit 114 can increase at least one of the acquisition frequency or the data acquisition item of the battery data when the state of use of battery pack 20 requires closer monitoring. Data acquisition control unit 114 can reduce at least one of the acquisition frequency or the data acquisition item of the battery data when the state of use of battery pack 20 no longer requires closer monitoring.

A specific example of determination criteria when the state of use of battery pack 20 requires closer monitoring is that battery pack 20 is under fast charging. Data acquisition control unit 114 can determine whether battery pack 20 is under fast charging, from a current value at the time when current data are in the polarity of charge.

Another specific example of the determination criteria when the state of use of battery pack 20 requires closer monitoring is that the depth of discharge (DOD) of battery pack 20 exceeds a reference level. Data acquisition control unit 114 can determine whether the DOD exceeds the reference level from a change in SOC at the time of discharge (more specifically, the degree of decrease in SOC).

Other specific examples of the determination criteria when the state of use of battery pack 20 requires closer monitoring are as follows: the outside air temperature is higher than a higher set value; and the outside air temperature is lower than a low set value. When outside air temperature data are transmitted from the ECU of electric vehicle 1 together with the battery data, data acquisition control unit 114 can determine whether the transmitted outside air temperature data are higher than the higher set value or lower than the lower set value. In addition, when the location information of electric vehicle 1 is transmitted from the ECU of electric vehicle 1 together with the battery data, data acquisition control unit 114 can estimate the outside air temperature of electric vehicle 1, based on the transmitted location information and weather information of the area of the location. In addition, when neither the outside air temperature data nor the location information of electric vehicle 1 is transmitted from the ECU of electric vehicle 1, data acquisition control unit 114 may estimate the outside air temperature of electric vehicle 1, based on weather information of the area of a business office that electric vehicle 1 belongs to.

Another specific example of the determination criteria when the state of use of battery pack 20 requires closer monitoring is that a predetermined period has not elapsed yet since the start of sales of battery pack 20 as a new product. Immediately after the release of the new product, there is a possibility that an unexpected trouble may occur in battery pack 20, hence battery pack 20 needs to be more closely monitored.

Another specific example of the determination criteria when the state of use of battery pack 20 requires closer monitoring is that electric vehicle 1 is a commercial vehicle. Compared to passenger vehicles, commercial vehicles are more frequently used, hence battery pack 20 is under heavy loads.

Another specific example of the determination criteria when the state of use of battery pack 20 requires closer monitoring is that auxiliary equipment (for example, an air conditioner) of electric vehicle 1 is more frequently used. When information on the period of use of a vehicle air conditioner is transmitted from the ECU of electric vehicle 1 together with the battery data, data acquisition control unit 114 can specify the usage frequency of the vehicle air conditioner.

Another specific example of the determination criteria when the state of use of battery pack 20 requires closer monitoring is that a predetermined period has not elapsed yet since the correction of an error. Another specific example of the determination criteria when the state of use of battery pack 20 requires closer monitoring is that the SOH is an SOH in the initial or end stage of use. In general, the SOH of many types of battery packs 20 sharply decreases in the initial stage of use, gradually decreases in the middle stage of use, and sharply decreases in the end stage of use. During the period of the sharp decrease, battery pack 20 is preferably more closely monitored.

Another specific example of the determination criteria when the state of use of battery pack 20 requires closer monitoring is that variations in SOOH estimated as a remaining life by battery state analysis unit 113 differ by a predetermined value or more from variations in SOH based on actual measured values.

Another specific example of the determination criteria when the state of use of battery pack 20 requires closer monitoring is that battery pack 20 has a battery parameter different by a predetermined value or more from those of other battery packs 20 used in the same manner. For example, when the SOH of specific battery pack 20 out of a plurality of battery packs 20 installed in the same type of electric vehicles 1 provided in the same business office at the same period is different by a predetermined value or more from the average of the SOHs of battery packs 20, specific battery pack 20 is preferably more closely monitored.

Data acquisition control unit 114 can adaptively increase or decrease at least one of the acquisition frequency or the data acquisition item of the battery data in accordance with the charge and discharge state of battery pack 20. Data acquisition control unit 114 can decrease at least one of the acquisition frequency or the data acquisition item of the battery data when electric vehicle 1 is turned off or electric vehicle 1 is in long term storage. Data acquisition control unit 114 can increase at least one of the acquisition frequency or the data acquisition item of the battery data when charge or discharge of battery pack 20 is restarted.

Data acquisition control unit 114 can determine whether electric vehicle 1 is turned off, based on whether current data indicate substantially zero. Data acquisition control unit 114 can determine whether electric vehicle 1 is in long term storage, based on the length of a period during which current data indicate substantially zero. Even when electric vehicle 1 is tuned off or electric vehicle 1 is in long term storage, battery data can be sampled and transmitted to battery analysis system 10 by periodically starting up BMS 25 and the ECU.

When electric vehicle 1 is in long term storage, data acquisition control unit 114 may make the acquisition frequency of the battery data lower than acquisition frequency when electric vehicle 1 is turned off. For example, in the case where the acquisition frequency of battery data is once a day when electric vehicle 1 is turned off, the acquisition frequency of battery data when electric vehicle 1 is in long term storage may be once a week or once a month.

When battery pack 20 has an abnormality or a sign of abnormality, when battery pack 20 deteriorates beyond the reference level, or when the state of use of battery pack 20 requires closer monitoring, data acquisition control unit 114 executes at least one of increasing the acquisition frequency of the battery data, increasing the data acquisition item, increasing analysis frequency, or increasing the analysis item. The monitoring accuracy of battery pack 20 can be thus enhanced. In other words, maintenance and operation costs of a cloud server and communication costs even in a period in which the above-mentioned criteria are not satisfied can be reduced.

As an example of increasing the analysis item, battery state analysis unit 113 executes the first battery internal short circuit detection when battery pack 20 has neither an abnormality nor a sign of abnormality, meanwhile executes both the first battery internal short circuit detection and the second battery internal short circuit detection when battery pack 20 has an abnormality or a sign of abnormality.

As an example of increasing analysis frequency, battery state analysis unit 113 analyzes an SOH once a week when battery pack 20 does not deteriorate beyond the reference level, meanwhile analyzes an SOH once a day when battery pack 20 deteriorates beyond the reference level.

When battery pack 20 is in a suspension state of neither charge nor discharge, data acquisition control unit 114 executes at least one of decreasing the acquisition frequency of the battery data, decreasing the data acquisition item of the battery data, decreasing the analysis frequency of the battery data, or decreasing the analysis item of the battery data. Maintenance and operation costs of a cloud server and communication costs can be thus reduced.

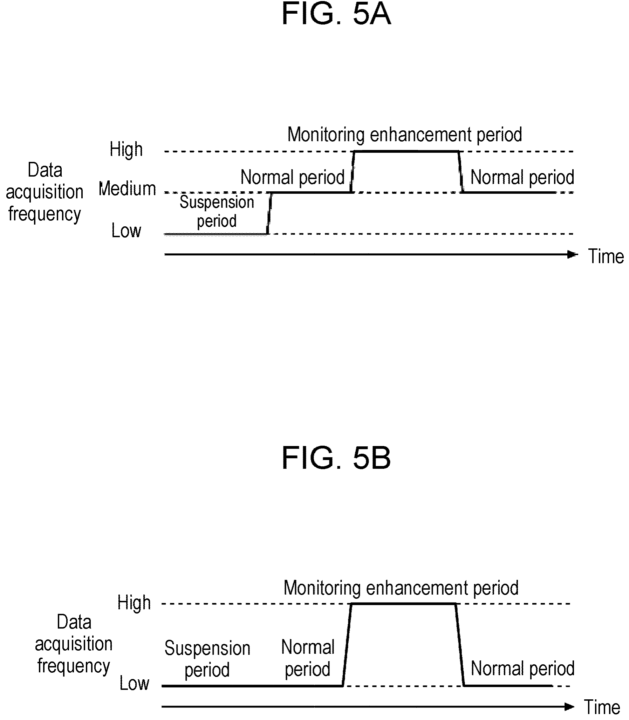

Fig. 5A is a diagram illustrating Control Example 1 of controlling the acquisition frequency of battery data. In the example illustrated in Fig. 5A, data acquisition control unit 114 sets the acquisition frequency of the battery data for the suspension period of neither charge nor discharge to "low", sets the acquisition frequency of the battery data for a normal period to "medium", and sets the acquisition frequency of the battery data for a monitoring enhancement period to "high". For example, battery data are acquired at intervals of 10 minutes for the period for which the acquisition frequency of the battery data is set to "low", acquired at intervals of 1 minute for the period for which the acquisition frequency is set to "medium", and acquired at intervals of 10 seconds for the period for which the acquisition frequency is set to "high".

Fig. 5B is a diagram illustrating Control Example 2 of controlling the acquisition frequency of battery data. In the example illustrated in Fig. 5B, data acquisition control unit 114 sets the acquisition frequency of battery data for the suspension period of neither charge nor discharge and the normal period to "low" and sets the acquisition frequency of battery data for the monitoring enhancement period to "high". For example, the battery data are acquired at intervals of 10 minutes for the period for which the acquisition frequency of battery data is set to "low" and acquired at intervals of 10 seconds for the period for which the acquisition frequency is set to "high". In the example illustrated in Fig. 5B, the amount of the battery data stored in battery data retention unit 121 can be further reduced.

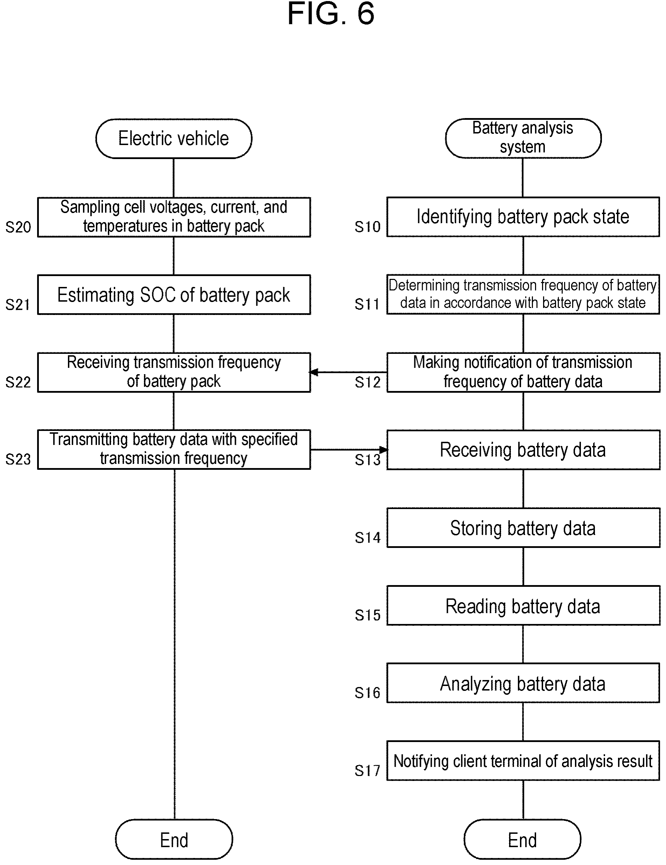

Fig. 6 is a flowchart to describe Control Example 1 of controlling the amount of battery data by battery analysis system 10 according to the embodiment. BMS 25 of battery pack 20 installed in electric vehicle 1 samples cell voltages measured by voltage sensor 22, a current flowing through battery pack 20 and measured by current sensor 23, and temperatures measured by a plurality of temperature sensors 24 provided at a plurality of observation points in battery pack 20 with a predetermined sampling frequency (S20). BMS 25 estimates the SOC of battery pack 20, based on the cell temperatures and the current (S21).

Data acquisition control 114 of battery analysis system 10 identifies the state of battery pack 20 (S10). Data acquisition control unit 114 determines the transmission frequency of the battery data in accordance with the identified state of battery pack 20 (S11). Notification unit 115 notifies electric vehicle 1 of the transmission frequency of the battery data that is determined by data acquisition control unit 114 (S12).

The ECU of electric vehicle 1 receives the transmission frequency of the battery data from battery analysis system 10 (S22). The ECU transmits the battery data (the cell voltages, the current, the temperatures, and the SOC) received from BMS 25 to battery analysis system 10 with the determined transmission frequency of (S23). Note that the sampling frequency of the battery data in BMS 25 can be changed to the sampling frequency corresponding to the determined transmission frequency. Also in this case, the transmission frequency of the battery data transmitted from the ECU to battery analysis system 10 is equal to the specified transmission frequency.

Data receiving unit 111 of battery analysis system 10 receives the battery data from electric vehicle 1 (S13). Data receiving unit 111 stores the received battery data in battery data retention unit 121 (S14). Battery state analysis unit 113 reads out the battery data from battery data retention unit 121 at a predetermined analysis timing (S15). Battery state analysis unit 113 analyzes a selected analysis item (S16). Notification unit 115 transmits analysis results to a terminal device belonging to a client (S17).

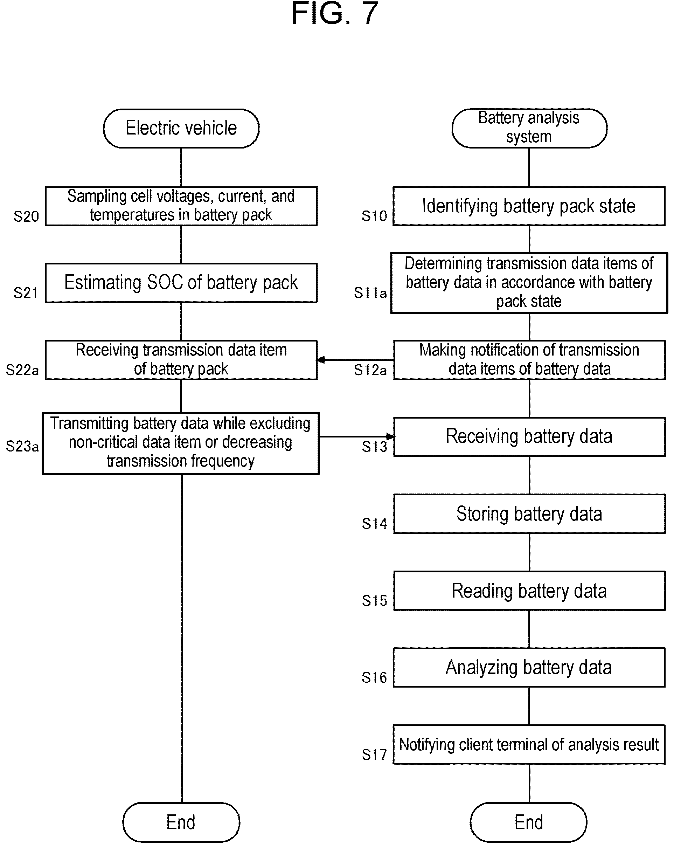

Fig. 7 is a flowchart to describe Control Example 2 of controlling the amount of battery data by battery analysis system 10 according to the embodiment. Descriptions of processes similar to those in the flow chart illustrated in Fig. 6 will be omitted. Data acquisition control unit 114 of battery analysis system 10 determines a transmission data item of the battery data in accordance with the state of battery pack 20 (S11a). Notification unit 115 notifies electric vehicle 1 of the transmission data item of the battery data that are determined by data acquisition control unit 114 (S12a).

The ECU of electric vehicle 1 receives the transmission data item of the battery data from battery analysis system 10 (S22a). Out of the battery data received from BMS 25 (the cell voltages, the current, the temperatures, and the SOC), the ECU transmits battery data received from BMS 25 to battery analysis system 10, excluding the non-critical data items identified from the received transmission data item or reducing the transmission frequency of the non-critical data items (S23a). Note that, when the battery data are sampled by BMS 25, sampling the non-critical data items may be stopped or the sampling frequency of the non-critical data items may be decreased. Also in this case, battery data transmitted from the ECU to battery analysis system 10 are the same as those mentioned above.

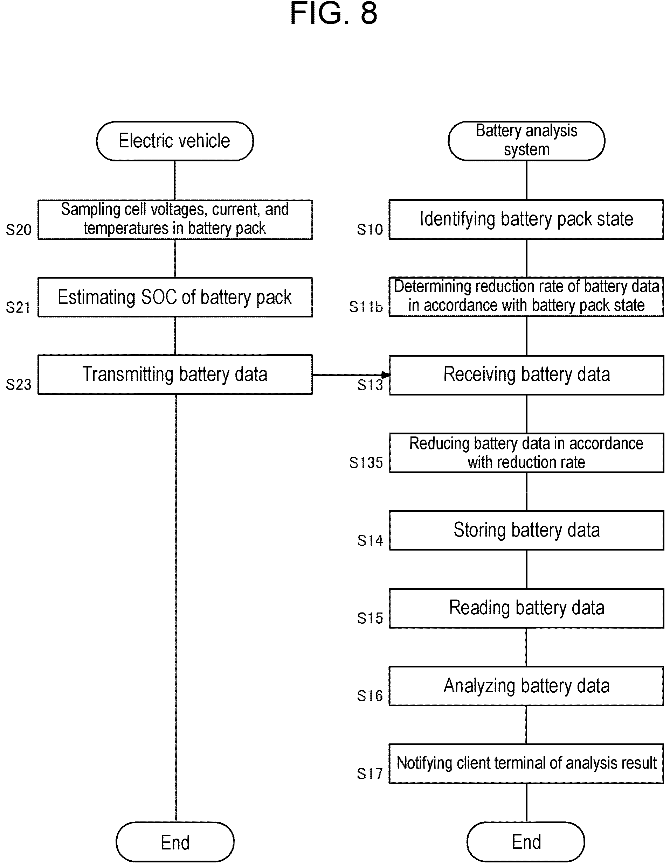

Fig. 8 is a flowchart to describe Control Example 3 of controlling the amount of battery data by battery analysis system 10 according to the embodiment. Descriptions of processes similar to those in the flow chart illustrated in Fig. 6 will be omitted. Data acquisition control unit 114 of battery analysis system 10 determines the reduction rate of the battery data in accordance with the state of battery pack 20 (S11b). Electric vehicle 1 is not notified of the determined reduction rate. Data reduction unit 112 reduces the battery data received from electric vehicle 1 in accordance with the determined reduction rate (S135).

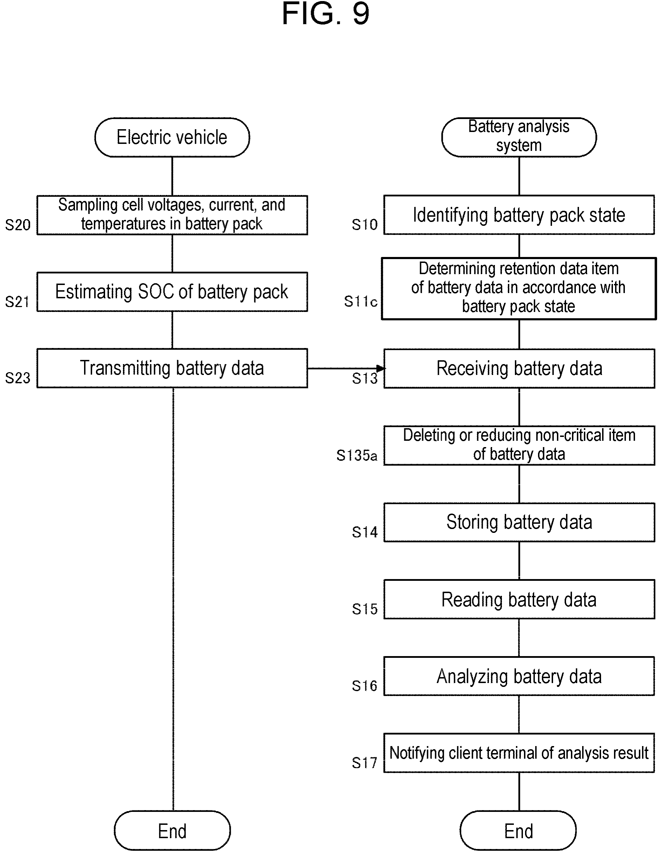

Fig. 9 is a flowchart to describe Control Example 4 of controlling the amount of battery data by battery analysis system 10 according to the embodiment. Descriptions of processes similar to those in the flow chart illustrated in Fig. 6 will be omitted. Data acquisition control unit 114 of battery analysis system 10 determines a storage data item of the battery data in accordance with the state of battery pack 20 (S11c). In Control Example 4, electric vehicle 1 is not notified of the storage data item. Data reduction unit 112 deletes or reduces battery data of the non-critical data items identified from the determined storage data item (S135a).

As described above, according to the present embodiment, the balance between the monitoring accuracy of the battery pack and the amount of battery data stored can be optimized by adaptively increasing or decreasing at least one of the acquisition frequency or the data acquisition item of the battery data in accordance with the state of battery pack 20.

For example, by reducing at least one of the acquisition frequency or the data acquisition item of the battery data during the suspension period of battery pack 20, the amount of use of a cloud database can be substantially prevented from increasing. In general, cloud database usage fees are based on a pay-as-you-go basis, and, as the amount of a cloud database used, the fees paid to a cloud service provider increase. In this case, the profits of a battery analysis service provider worsen, or the increase in the fees needs to be passed on to customers. When the increase in the fees is passed on to customers, the number of customers may decrease. In the present embodiment, server costs can be reduced by substantially preventing the amount of use during the suspension period from increasing.

In the analysis during the suspension period, a small amount of battery data is used, whereby analysis time can be shorter. When a contract to increase fees to be paid a cloud service provider in accordance with the operating time of a server is made, reduction in analysis time also leads to reduction in server costs.

In addition, when the amount of battery data transmitted to battery analysis system 10 in electric vehicle 1 is reduced, communication loads can be reduced. When battery data are transmitted using a cellular network, communication charges can be reduced.

In addition, when battery pack 20 has an abnormality or a sign of abnormality, when battery pack 20 deteriorates beyond the reference level, or when the state of use of battery pack 20 requires closer monitoring, monitoring accuracy can be enhanced by increasing the amount of battery data.

The present disclosure has been so far described, based on the embodiment. Those skilled in the art will understand that the embodiment is merely an example and various modifications can be made to a combination of the constituents and a combination of the processing processes and such modifications are also included within the scope of the present disclosure.

In the above-described embodiment, a four-wheel electric vehicle is assumed as electric vehicle 1. Here, electric vehicle 1 may be an electric motorbike (an electric scooter), an electric-assisted bicycle, or an electric kick-scooter. Examples of the electric vehicle include not only full-standard electric vehicles, but also low-speed electric vehicles such as golf carts and land cars. In these cases, smartphones may be used as data relay system 40.

The apparatus in which battery pack 20 is installed is not limited to electric vehicle 1. Examples of the apparatus in which battery pack 20 is installed also include electric ships, railway vehicles, electric mobile objects such as multicopters (drones), stationary energy storage systems, consumer electronic devices (such as smart phones and notebook PCs).

Note that the embodiment may be specified by the following items.

### [Item 1]

A battery analysis system (10), including:
a data receiving unit (111) configured to receive, via an apparatus (1) or a data relay system (40), battery data of a battery pack (20) installed in an apparatus (1) in real time;
a battery data retention unit (121) configured to store the battery data received by the data receiving unit (111);
a battery state analysis unit (113) configured to read the battery data from the battery data retention unit (121), and analyze the battery data read to estimate a battery state of the battery pack (20); and
a data acquisition control unit (114) configured to, in accordance with the battery state analyzed by the battery state analysis unit (113), adaptively increase or decrease at least one of (i) an acquisition frequency of battery data that is received from the apparatus (1) or the data relay system (40) by the data receiving unit (111) and stored in the battery data retention unit (121), or (ii) a data acquisition item of the battery data t that is received from the apparatus (1) or the data relay system (40) by the data receiving unit (111) and stored in the battery data retention unit (121).

With this configuration, the balance between the accuracy of monitoring the battery pack (20) and the amount of the battery data stored can be optimized.

### [Item 2]

The battery analysis system (10) according to Item 1, wherein, when the battery pack (20) has an abnormality or a sign of abnormality, the data acquisition control unit (114) increases at least one of the acquisition frequency or the data acquisition item.

With this configuration, when the battery pack (20) has an abnormality or a sign of abnormality, the accuracy of monitoring the battery pack (20) can be enhanced.

### [Item 3]

The battery analysis system (10) according to Item 2, wherein, when an abnormality is detected in the battery pack (20) from an analysis result of the battery data, when a sign of abnormality is detected in the battery pack (20) from the analysis result of the battery data, or when battery data belong to battery pack (20) whose model number is identical to that of the battery pack (20) having the abnormality, the data acquisition control unit (114) increases at least one of the acquisition frequency or the data acquisition item.

With this configuration, the accuracy of monitoring the battery pack (20) can be enhanced when the conditions are satisfied.

### [Item 4]

The battery analysis system (10) according to Item 1, wherein, when the battery pack (20) deteriorates beyond a reference level, the data acquisition control unit (114) increases at least one of the acquisition frequency or the data acquisition item.

With this configuration, the accuracy of monitoring the battery pack (20) can be enhanced when the battery pack (20) deteriorates beyond the reference level.

### [Item 5]

The battery analysis system (10) according to Item 4, wherein, when the state of health (SOH) of the battery pack (20) is lower than the reference level, when the period of use of the battery pack (20) exceeds the reference level, or when the number of charge and discharge cycles for the battery pack (20) exceeds the reference level, the data acquisition control unit (114) increases at least one of the acquisition frequency or the data acquisition item.

With this configuration, the accuracy of monitoring the battery pack (20) can be enhanced when the conditions are satisfied.

### [Item 6]

The battery analysis system (10) according to Item 1, wherein, when the state of use of the battery pack (20) needs closer monitoring, the data acquisition control unit (114) increases at least one of the acquisition frequency or the data acquisition item.

With this configuration, the accuracy of monitoring the battery pack (20) can be enhanced when the state of use of the battery pack (20) needs closer monitoring.

### [Item 7]

The battery analysis system (10) according to Item 6, wherein, when the battery pack (20) is under fast charging, when the depth of discharge (DOD) of the battery pack (20) exceeds a reference level, when the outside air temperature is higher than a higher set value, when the outside air temperature is lower than a lower set value, or when a predetermined period has not elapsed yet since the start of sale of the battery pack (20) as a new product, the data acquisition control unit (114) increases at least one of the acquisition frequency or the data acquisition item.

With this configuration, the accuracy of monitoring the battery pack (20) can be enhanced when the conditions are satisfied.

### [Item 8]

The battery analysis system (10) according to Item 1, wherein the data acquisition control unit (114) increases at least one of the acquisition frequency or the data acquisition item in accordance with the state of charge and discharge of the battery pack (20).

With this configuration, the balance between the accuracy of monitoring the battery pack (20) and the amount of battery data stored can be optimized in accordance with the state of charge and discharge of the battery pack (20).

### [Item 9]

The battery analysis system (10) according to Item 1, wherein, when the apparatus (1) is turned off or when the apparatus (1) is in long term storage, the data acquisition control unit (114) increases at least one of the acquisition frequency or the data acquisition item.

With this configuration, the amount of battery data stored can be reduced when the conditions are satisfied.

### [Item 10]

The battery analysis system (10) according to Item 1, wherein the data receiving unit (111) receives specification information on at least one of the battery pack (20) or the apparatus (1).

With this configuration, the state of the battery pack (20) can be determined.

### [Item 11]

The battery analysis system (10) according to Item 1, wherein, in accordance with the state of the battery pack (20), the battery state analysis unit (113) adaptively increases or decreases an analysis item or the frequency of analysis using the battery data.

With this configuration, in accordance with the state of the battery pack (20), operating time to be spent for the analysis of the battery pack (20) can be optimized.

### [Item 12]

The battery analysis system (10) according to Item 1, further including:
a notification unit (115) configured to notify the apparatus (1) or the data relay system (40) of a predetermined instruction,
wherein the data acquisition control unit (114) determines the transmission frequency of the battery data in accordance with the state of the battery pack (20), and
the notification unit (115) notifies the apparatus (1) or the data relay system (40) of the determined transmission frequency of the battery data.

With this configuration, the amount of the battery data stored can be optimized by changing the transmission frequency of the battery data transmitted from the apparatus (1) or the data relay system (40).

### [Item 13]

The battery analysis system (10) according to Item 1, further including:
a data reduction unit (112) configured to reduce the battery data received from the apparatus (1) or the data relay system (40),
wherein the data acquisition control unit (114) determines the reduction rate of the battery data in accordance with the state of the battery pack (20), and
the data reduction unit (112) reduces the battery data in accordance with the determined reduction rate.

With this configuration, the amount of battery data stored can be optimized by reducing the battery data to be stored.

### [Item 14]

The battery analysis system (10) according to Item 1, further including:
a notification unit (115) configured to notify the apparatus (1) or the data relay system (40) of a predetermined instruction,
wherein the battery pack (20) includes a plurality of cells connected in series (E1-Em) or a plurality of cell blocks (Ebl-Ebm) connected in series, each of the cell blocks including a corresponding set of cells (Ela-Eln to Ema-Emn),
a battery management system (25) of the apparatus (1) acquires, as a monitoring data item of the battery pack (20), voltages of each of the plurality of cells (El-Em) or each of the plurality of cell blocks (Ebl-Ebm), a current flowing through the battery pack (20), and a temperature measured by at least one temperature sensor provided in the battery pack (20) every predetermined sampling period,
the data acquisition control unit (114) determines a transmission data item of the battery data in accordance with the state of the battery pack (20), and
the notification unit (115) notifies the apparatus (1) or the data relay system (40) of the determined transmission data item of the battery data.

With this configuration, by changing the transmission data item of the battery data transmitted from the apparatus (1) or the data relay system (40), the amount and contents of the battery data stored can be optimized.

### [Item 15]

The battery analysis system (10) according to Item 1, further including:
a data reduction unit (112) configured to reduce the battery data received from the apparatus (1) or the data relay system (40),
wherein the battery pack (20) includes a plurality of cells connected in series (E1-Em) or a plurality of cell blocks (Ebl-Ebm) connected in series, each of the cell blocks including a corresponding set of cells (Ela-Eln to Ema-Emn),
a battery management system (25) of the apparatus (1) acquires, as a monitoring data item of the battery pack (20), cell voltages of each of the plurality of the cells (El-Em) or each of the plurality of the cell blocks (Ebl-Ebm), a current flowing through the battery pack (20), and a temperature measured by at least one temperature sensor provided in the battery pack every predetermined sampling period,
the data acquisition control unit (114) determines a non-critical data item of the battery data in accordance with the state of the battery pack (20), and
the data reduction unit (112) change whether to delete data of the determined non-critical data item or whether to reduce data of the determined non-critical data item determined.

With this configuration, the amount and contents of the battery data stored can be optimized by limiting a deletion or reduction target to the data of the non-critical data item.

### [Item 16]

A battery analysis method, including:
receiving battery data of a battery pack (20) installed in an apparatus (1) via the apparatus (1) or a data relay system (40) in real time;
storing the received battery data in a battery data retention unit (121);
reading the battery data and analyzing the battery data read to estimate a battery state; and,
in accordance with the state of the battery pack (20), adaptively increasing or decreasing at least one of (i) an acquisition frequency of battery data that is received from apparatus (1) or the data relay system (40) and stored in the battery data retention unit (121) or (ii) a data acquisition item of the battery data received from the apparatus (1) or the data relay system (40) and stored in the battery data retention unit (121).

With this configuration, the balance between the accuracy of monitoring the battery pack (20) and the amount of the battery data stored can be optimized.

### [Item 17]

A battery analysis program configured to cause a computer to execute:
receiving battery data of a battery pack (20) installed in an apparatus (1) via the apparatus (1) or a data relay system (40) in real time;
storing the received battery data in a battery data retention unit (121);
reading the battery data and analyzing the read battery data to estimate a battery state; and,
in accordance with the state of the battery pack (20), adaptively increasing or decreasing at least one of (i) an acquisition frequency of battery data that is or a data acquisition item of the battery data that is received from apparatus (1) or the data relay system (40) and stored in the battery data retention unit (121) or (ii) a data acquisition item of the battery data received from the apparatus (1) or the data relay system (40) and stored in the battery data retention unit (121).

With this configuration, the balance between the accuracy of monitoring the battery pack (20) and the amount of the battery data stored can be optimized.

### REFERENCE MARKS IN THE DRAWINGS

1...electric vehicle
2...commercial power system
5...networks
10...battery analysis system
11...control unit
12...memory unit
13...communication unit
20...battery pack
21...battery assembly system
22...voltage sensor
23...current sensor
24...temperature sensor
25...BMS
26...communication unit
30...charge stand
31...power supply unit
32...control unit
33...communication unit
40...data relay system
111...data receiving unit
112...data reduction unit
113...battery state analysis unit
114...data acquisition control unit
115...notification unit
121...battery data retention unit

## Claims

1. A battery analysis system, comprising:
a data receiving unit configured to receive, via an apparatus or a data relay system, battery data of a battery pack installed in the apparatus in real time;
a battery data retention unit configured to store the battery data received by the data receiving unit;
a battery state analysis unit configured to read the battery data from the battery data retention unit, and analyze the battery data read to estimate a battery state of the battery pack; and
a data acquisition control unit configured to, in accordance with the battery state analyzed by the battery state analysis unit, adaptively increase or decrease at least one of (i) an acquisition frequency of battery data that is received from the apparatus or the data relay system by the data receiving unit and stored in the battery data retention unit, or (ii) a data acquisition item of the battery data that is received from the apparatus or the data relay system by the data receiving unit and stored in the battery data retention unit.

2. The battery analysis system according to Claim 1, wherein, when the battery pack has an abnormality or a sign of abnormality, the data acquisition control unit increases at least one of the acquisition frequency or the data acquisition item.

3. The battery analysis system according to Claim 2, wherein, when an abnormality is detected in the battery pack from an analysis result of the battery data, when a sign of abnormality is detected in the battery pack from the analysis result of the battery data, or when battery data belong to a battery pack whose model number is identical to a model number of the battery pack having the abnormality, the data acquisition control unit increases at least one of the acquisition frequency or the data acquisition item.

4. The battery analysis system according to Claim 1, wherein, when the battery pack deteriorates beyond a reference level, the data acquisition control unit increases at least one of the acquisition frequency or the data acquisition item.

5. The battery analysis system according to Claim 4, wherein, when a state-of-health of the battery pack is lower than the reference level, when a period of use of the battery pack exceeds the reference level, or when the number of charge and discharge cycles for the battery pack exceeds the reference level, the data acquisition control unit increases at least one of the acquisition frequency or the data acquisition item.

6. The battery analysis system according to Claim 1, wherein, when a state of use of the battery pack requires closer monitoring, the data acquisition control unit increases at least one of the acquisition frequency or the data acquisition item.

7. The battery analysis system according to Claim 6, wherein, when the battery pack is under fast charging, when a depth of discharge of the battery pack exceeds a reference level, when an outside air temperature is higher than a higher set value, when an outside air temperature is lower than a lower set value, or when a predetermined period does not elapsed yet since start of sale of the battery pack as a new product, the data acquisition control unit increases at least one of the acquisition frequency or the data acquisition item.

8. The battery analysis system according to Claim 1, wherein the data acquisition control unit increases at least one of the acquisition frequency or the data acquisition item in accordance with a state of charge and discharge of the battery pack.

9. The battery analysis system according to Claim 8, wherein, when the apparatus is turned off or when the apparatus is in long term storage, the data acquisition control unit increases at least one of the acquisition frequency or the data acquisition item.

10. The battery analysis system according to Claim 1, wherein the data receiving unit receives specification information on at least one of the battery pack or the apparatus.

11. The battery analysis system according to Claim 1, wherein, in accordance with the state of the battery pack, the battery state analysis unit adaptively increases or decreases an analysis item or the frequency of analysis using the battery data.

12. The battery analysis system according to Claim 1, further comprising
a notification unit configured to notify the apparatus or the data relay system of a predetermined instruction,
wherein the data acquisition control unit determines transmission frequency of the
battery data in accordance with the state of the battery pack, and
the notification unit notifies the apparatus or the data relay system of the transmission frequency of the battery data determined.

13. The battery analysis system according to Claim 1, further comprising
a data reduction unit configured to reduce the battery data received from the apparatus or the data relay system,
wherein the data acquisition control unit determines a reduction rate of the battery data in accordance with the state of the battery pack, and
the data reduction unit reduces the battery data in accordance with the reduction rate determined.

14. The battery analysis system according to Claim 1, further comprising
a notification unit configured to notify the apparatus or the data relay system of a predetermined instruction,
wherein the battery pack includes a plurality of cells connected in series or a plurality of cell blocks connected in series, each of the cell blocks including the plurality of cells,
a battery management system of the apparatus acquires, as a monitoring data item of the battery pack, voltage of each of plurality of the cells or each of the plurality of cell blocks, a current flowing through the battery pack, and a temperature measured by at least one temperature sensor provided in the battery pack every predetermined sampling period,
the data acquisition control unit determines a transmission data item of the battery data in accordance with the state of the battery pack, and
the notification unit notifies the apparatus or the data relay system of the data transmission data item determined of the battery data.

15. The battery analysis system according to Claim 1, further comprising
a data reduction unit configured to reduce the battery data received from the apparatus or the data relay system,
wherein the battery pack includes a plurality of cells connected in series or a plurality of cell blocks connected in series, each of the cell blocks including the plurality of cells,
a battery management system of the apparatus acquires, as a monitoring data item of the battery pack, voltage of each of plurality of the cells or each of the plurality of cell blocks, a current flowing through the battery pack, and a temperature measured by at least one temperature sensor provided in the battery pack every predetermined sampling period,
the data acquisition control unit determines a non-critical data item of the battery data in accordance with the state of the battery pack, and
the data reduction unit changes whether to delete data of the non-critical data item determined or whether to reduce the data of the non-critical data item determined.

16. A battery analysis method, comprising:
receiving battery data of a battery pack installed in an apparatus via the apparatus or a data relay system in real time;
storing the received battery data in a battery data retention unit;
reading the battery data and analyzing the battery data read to estimate a battery state; and,
in accordance with the state of the battery pack, adaptively increasing or decreasing at least one of (i) an acquisition frequency of battery data that is received from the apparatus or the data relay system and stored in the battery data retention unit or (ii) a data acquisition item of the battery data received from the apparatus or the data relay system and stored in the battery data retention unit.

17. A battery analysis program configured to cause a computer to execute:
receiving battery data of a battery pack installed in an apparatus via the apparatus or a data relay system in real time;
storing the battery data received in a battery data retention unit;
reading the battery data and analyzing the battery data read to estimate a battery state; and,
in accordance with a state of the battery pack, adaptively increasing or decreasing at least one of (i) an acquisition frequency of battery data that is received from the apparatus or the data relay system and stored in the battery data retention unit or (ii) a data acquisition item of the battery data received from the apparatus or the data relay system and stored in the battery data retention unit.

18. A transitory storage medium with a battery analysis program recorded in the transitory storage medium, the transitory storage medium causing a computer to execute the battery analysis program according to Claim 17.
